# FASCICULE DE BREVET EUROPEEN

(11) **EP 1 394 939 B1**
(45) Date de publication et mention de la délivrance du brevet: **20.05.2009**
(21) Numéro de dépôt: 03300094.4
(22) Date de dépôt: 26.08.2003
(51) Int. Cl.: H03G 3/30, G05B 6/02

(54) **Commande en boucle fermée d'un système analogique fournissant un signal de sortie à partir d' un signal de commande.**
Mit geschlossener Schleife gesteuertes analogues System zur Generierung eines Ausgangssignals aus einem Steuersignal
Closed-loop control of an analog system producing an output signal from a control signal

(30) Priorité: 29.08.2002 FR 0210721
(43) Date de publication de la demande: 03.03.2004
(73) Titulaire: STMicroelectronics S.A., 92120 Montrouge (FR)
(72) Inventeur: Lagoguez, Bruno, 38420 Le Versoud (FR); Della Monica, M. Gabriel, 38430, Moirans (FR)
(74) Mandataire: de Beaumont, Michel

(56) Documents cités:
- EP-A- 0 688 108
- WO-A-01/58013
- US-A- 6 020 787

## Description

La présente invention concerne un procédé et un dispositif de commande d'un système analogique fournissant un signal de sortie par un signal de commande.

Une application de la présente invention concerne la commande d'un amplificateur de signaux d'un système d'émission de téléphone portable.

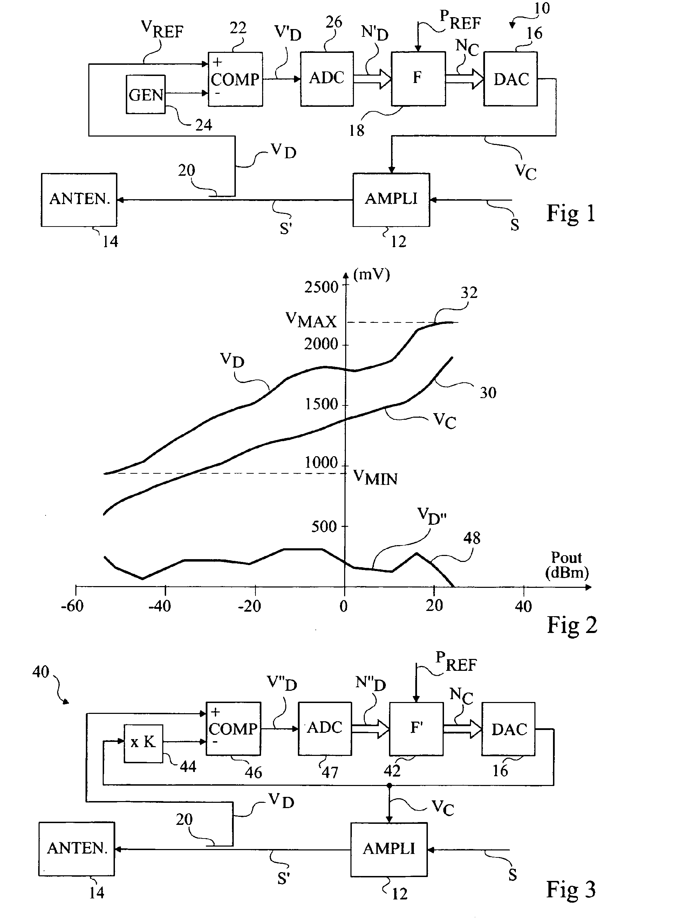

La figure 1 représente, sous forme d'un schéma par blocs, une architecture habituelle d'un système d'émission 10 de téléphone portable.

Le système d'émission 10 comprend un amplificateur 12 (AMPLI) recevant un signal S analogique comportant l'information à émettre correspondant, par exemple, à une tension modulée. L'amplificateur 12 transmet un signal S' analogique amplifié à une antenne 14 (ANTEN).

Le système d'émission 10 reçoit généralement une consigne numérique P_{REF} généralement transmise au téléphone portable par une station à distance et correspondant par exemple à une valeur de puissance déterminée à laquelle le signal S' doit être émis.

L'amplificateur 12 est piloté par un signal de commande analogique V_{C} qui correspond à la conversion par un convertisseur numérique/analogique 16 (DAC) d'un signal de commande numérique N_{C} fourni par un calculateur 18 (F). Le calculateur 18 reçoit le signal P_{REF} et a accès à une mémoire (non représentée) dans laquelle est stockée une table de commande indiquant pour des valeurs de puissance visées des valeurs théoriques du signal de commande.

En pratique, la puissance du signal S' peut différer de la puissance théorique en fonction de certains paramètres tels que la température de fonctionnement de l'amplificateur 12, la tension d'alimentation du téléphone portable, ou d'autres paramètres externes. Il est donc nécessaire de corriger le signal de commande théorique. Ceci est couramment réalisé par une commande en boucle fermée de la puissance du signal S' fourni par l'amplificateur 12.

Un capteur 20 fournit à partir du signal S' un signal de détection analogique V_{D} à l'entrée non inverseuse d'un comparateur 22 (COMP). Le signal V_{D} peut correspondre à une tension égale à la valeur de crête du signal S' ou à la valeur moyenne du signal S'. Un générateur 24 (GEN) fournit un signal de référence V_{REF}, généralement une tension constante, à l'entrée inverseuse du comparateur 22 qui transmet à un convertisseur analogique-numérique 26 (ADC) un signal analogique de détection modifié V'_{D} correspondant à la différence entre le signal V_{D} et le signal de référence V_{REF}. Le convertisseur 26 convertit le signal V'_{D} en un signal de détection numérique N'_{D} transmis au calculateur 18. Le calculateur 18 a également accès à une mémoire (non représentée) où est stockée une table de détection indiquant pour des valeurs données du signal N'_{D} les valeurs correspondantes de la puissance du signal S'. Le signal N_{C} est fourni par le calculateur 18 qui corrige la valeur théorique susmentionnée par l'indication fournie par la table de détection.

En figure 2, les courbes 30 et 32 représentent, pour des conditions données de fonctionnement de l'amplificateur, les tensions V_{C} et V_{D} en fonction de la puissance P_{OUT} du signal S' exprimée en dBm. La puissance P_{OUT} est donc égale à 10logP où P est la puissance du signal S' exprimée en milliwatts. Plus particulièrement, la courbe 30 représente la relation réelle, pour les conditions de fonctionnement données, entre la tension V_{C} et la puissance P_{OUT} du signal S' réellement fournie par l'amplificateur 12 à réception du signal V_{C}.

La régulation de la puissance du signal de sortie S' est réalisée de la façon suivante. A partir de la consigne de puissance P_{REF}, le calculateur 18 détermine une première valeur, ou valeur théorique, du signal numérique de commande N_{C} à partir de la table de commande. La valeur du signal V_{C} est celle pour laquelle l'amplificateur devrait théoriquement fournir un signal S' de puissance P_{REF}. A partir du signal N'_{D}, le calculateur 18 détermine la puissance réellement fournie par l'amplificateur 12 et augmente ou diminue en conséquence la valeur du signal N_{C}.

Comme cela apparaît en figure 2, le signal V_{D} peut varier entre deux valeurs positives V_{MIN} et V_{MAX}. Le signal V_{REF} est généralement pris égal à V_{MIN}. Le signal V'_{D} peut donc varier entre 0 et V_{MAX}-V_{MIN}. La valeur maximale de V'_{D} (V_{MAX}-V_{MIN)} est donc inférieure à la valeur maximale de V_{D} (V_{MAX}). Le signal V'_{D} pourra donc être codé par un plus petit nombre de bits que le signal V_{D} et le convertisseur 26 peut être simplifié.

Le nombre de bits du convertisseur 26 est également fonction de la précision avec laquelle on souhaite commander la puissance du signal S'. Dans le présent exemple, l'amplitude de la puissance est de 74 dBm. Si la précision souhaitée pour la commande de la puissance du signal de sortie S' est de 0,2 dB, le calculateur 18 doit pouvoir fournir 370 valeurs distinctes de N_{C}. En considérant que la relation entre V'_{D} et la puissance P_{OUT} est sensiblement linéaire et qu'à chaque valeur de V'_{D} entre 0 et V_{MAX}-V_{MIN} correspond une valeur de puissance, cela revient à dire que le convertisseur 26 doit pouvoir coder 370 valeurs différentes pour le signal N'_{D}. Un codage sur 9 bits permet de coder 512 valeurs différentes de tension V'_{D}.

L'amplitude de la tension V'_{D} étant de 1260 millivolts, la précision obtenue pour le codage de la tension V'_{D} est d'environ 2,5 millivolts.. Pour obtenir un codage de même précision pour le signal V_{D} qui a une amplitude de 2187 mV, un codage sur 10 bits serait nécessaire.

Avec l'évolution des normes de téléphonie mobile, la précision demandée pour la commande de la puissance du signal de sortie tend à augmenter.. Il est alors nécessaire d'augmenter le nombre de bits utilisés par le convertisseur analogique/numérique 26 pour coder un nombre plus important de valeurs différentes de la tension V'_{D}.

Ceci entraîne une augmentation du coût du convertisseur analogique/numérique 26 difficilement compatible avec les contraintes de coût propres à la téléphonie mobile.. En outre, selon la précision demandée, on peut atteindre les limites technologiques des convertisseurs analogique/numérique utilisés en téléphonie mobile et qui permettent le codage jusqu'à environ 14 bits.

Le document EP 0 688 108 décrit un système atténuateur variable analogique commandé par un signal de commande analogique issu d'un convertisseur numérique analogique qui recoit un signal fourni par un système numérique dont le signal d'entrée est produit par un comparateur comparant un signal de sortie du système atténuateur variable à un signal de référence.

La présente invention propose un procédé original de commande en boucle fermée d'un système analogique produisant un signal de sortie par un signal de commande.

Pour atteindre cet objet, elle prévoit un procédé de commande en boucle fermée d'un système analogique selon la revendication 1 et un système de commande selon la revendication 8.

Selon un mode de réalisation de l'invention, le système analogique produit un signal de sortie analogique et est commandé par un signal de commande analogique correspondant à la conversion du signal de commande numérique, ledit signal de commande numérique étant fourni par un système numérique qui produit des valeurs successives du signal de commande numérique à partir d'un signal de référence et d'un signal de détection numérique correspondant à la conversion d'un signal de détection analogique, une nouvelle valeur du signal de commande numérique étant déterminée selon les étapes consistant à mesurer un signal analogique représentatif du signal de sortie analogique ; déterminer le signal de détection analogique à partir de la différence entre le signal analogique représentatif et le signal de commande analogique multiplié par le facteur sélectionné ; convertir le signal de détection analogique en une nouvelle valeur de signal de détection numérique ; et calculer la nouvelle valeur du signal de commande numérique à partir de ladite nouvelle valeur du signal de détection numérique et de la dernière valeur du signal de commande numérique précédemment déterminée.

Selon un mode de réalisation de l'invention, le signal analogique représentatif et le signal de commande analogique sont de même signe, le signal de détection analogique correspondant à la différence entre le signal analogique représentatif et le signal de commande analogique multiplié par un coefficient d'amplification.

Selon un mode de réalisation de l'invention, le signal de sortie analogique est une tension variable.

Selon un mode de réalisation de l'invention, le signal analogique représentatif est une tension positive sensiblement égale à la valeur maximale du signal de sortie analogique.

Selon un mode de réalisation de l'invention, le signal de référence est représentatif de la puissance désirée du signal de sortie analogique.

Selon un mode de réalisation de l'invention, le coefficient d'amplification est constant.

Selon un mode de réalisation de l'invention, le coefficient d'amplification dépend des conditions de fonctionnement du système numérique.

La présente invention prévoit également un dispositif de commande d'un système analogique produisant un signal de sortie analogique comprenant un système numérique fournissant un signal de commande numérique ; un convertisseur numérique-analogique recevant le signal de commande numérique et fournissant un signal de commande analogique au système analogique ; et un capteur mesurant un signal analogique représentatif du signal de sortie analogique, comprenant en outre un comparateur fournissant un signal de détection analogique à partir du signal analogique représentatif et du signal de commande analogique ; et un convertisseur analogique-numérique convertissant le signal de détection analogique en un signal de détection numérique fourni au système numérique, ledit système numérique déterminant le signal de commande numérique à partir d'un signal de référence et du signal de détection numérique.

Selon un mode de réalisation de l'invention, le système analogique est un amplificateur de signaux d'un téléphone portable

Cet objet, ces caractéristiques et avantages, ainsi que d'autres de la présente invention seront exposés en détail dans la description suivante de modes de réalisation particuliers faite à titre non limitatif en relation avec les figures jointes parmi lesquelles :
la figure 1, précédemment décrite, représente sous forme d'un schéma par blocs une architecture classique d'un système d'émission de téléphone portable ;
la figure 2, précédemment décrite en partie, représente des exemples de courbes de signaux caractéristiques du système d'émission de la figure 1 en fonction de la puissance du signal à émettre ; et
la figure 3 représente sous forme d'un schéma par blocs un exemple de réalisation d'un système d'émission selon l'invention.

Le système d'émission 40 selon l'invention comprend, de façon identique au système 10 de la figure 1, un amplificateur 12 (AMPLI) recevant un signal analogique S et fournissant un signal de sortie analogique S' amplifié à une antenne 14 (ANTEN) et un capteur 20 mesurant un signal analogique V_{D} fonction du signal S'.

Un calculateur numérique 42 (F') reçoit une consigne de puissance P_{REF} et fournit un signal numérique de commande N_{C} à un convertisseur numérique/analogique 16 qui le convertit en un signal de commande analogique V_{C} transmis à l'amplificateur 12. Le signal V_{C} alimente également un amplificateur auxiliaire 44 (*K) qui amplifie par un coefficient K la valeur du signal analogique V_{C} et transmet le signal amplifié à l'entrée inverseuse d'un comparateur 46. L'entrée non inverseuse du comparateur 46 reçoit le signal V_{D} analogique mesuré par le capteur 20. Le comparateur 46 fournit un signal de détection modifié analogique V"_{D}=V_{D}-KV_{C} à un convertisseur analogique/numérique 47 qui convertit le signal V"_{D} en un signal numérique N"_{D} transmis au calculateur 42. Le calculateur 42 a accès à des tables de commande et de détection telles que mentionnées précédemment.

En figure 2, la courbe 48 représente le signal V"_{D} en fonction de la puissance P_{OUT} exprimée en dBm du signal de sortie S'. Le coefficient K peut être une constante déterminée empiriquement de sorte que le signal V"_{D} soit positif pour l'ensemble des valeurs de P_{OUT} possibles tout en ayant la plus faible amplitude possible. En figure 2, le coefficient K a été fixé à 1,15.

Le calcul des valeurs numériques du signal numérique N_{C} par le calculateur 42 se déroule selon les étapes suivantes.

Initialement, à réception d'une consigne de puissance P_{REF}, le calculateur 42 transmet une première valeur de signal numérique de commande N_{C} qui est convertie par le convertisseur 16 en un signal analogique de commande V_{C} transmis à l'amplificateur 12. L'amplificateur 12 produit en conséquence un signal S' amplifié à une puissance donnée et le capteur 20 mesure le signal analogique de détection V_{D}. Le convertisseur 47 reçoit du comparateur 46 le signal analogique V"_{D} et le convertit en signal numérique N"_{D}.

A réception du signal numérique N"_{D}, le calculateur 42 détermine une valeur numérique N'_{D} qui correspond à la valeur numérique qui serait issue de la conversion du signal V'_{D} mentionné précédemment en relation avec la figure 1. Le calcul est réalisé à partir de la valeur numérique N"_{D}, de la valeur du signal numérique de commande N_{C} précédemment calculée et du coefficient K connu du calculateur 42. A partir de la valeur numérique N'_{D} calculée, le calculateur 42 détermine au moyen de la table de détection la puissance réellement fournie par l'amplificateur 12 et la compare à la consigne P_{REF}. Selon le résultat de la comparaison, le calculateur 42 détermine une nouvelle valeur numérique du signal numérique de commande N_{C}.

La relation entre les signaux V"_{D}, V_{D} et V_{C} est linéaire. De ce fait, pour calculer la valeur numérique N'_{D}, il est suffisant de disposer, pour le codage du signal V"_{D}, d'une précision identique à celle qui était requise pour le signal V'_{D}. Or, comme l'amplitude du signal analogique V"_{D} est plus faible que celle des signaux V_{D} et V'_{D}, le nombre de bits nécessaires pour coder le signal V"_{D} pour une même précision de codage sera inférieur à celui d'un système d'émission classique. Dans l'exemple de la figure 2, le signal analogique V"_{D} présente une amplitude maximale de 303 millivolts. Pour obtenir une précision de 0,2 dB sur la commande de puissance, on a besoin d'une précision de 2,5 mV pour le codage du signal V"_{D}. Il faut donc pouvoir coder 122 états de V"_{D}. Un codage sur 7 bits est alors suffisant.

Selon une variante de l'invention, le coefficient K peut être variable selon les conditions de fonctionnement de l'amplificateur 12. En particulier, le coefficient K peut être fonction de la température de fonctionnement de l'amplificateur 12 ou de l'état de charge de batteries alimentant l'amplificateur 12.

Selon une autre variante de l'invention, dans le cas où la relation entre la tension V_{D} et la puissance P_{OUT} exprimée en dBm ne peut être considérée comme une relation linéaire, on pourra multiplier le nombre d'états à coder pour le signal V"_{D} par un facteur de correction fonction de la pente maximale de la courbe représentative du signal V_{D} en fonction de P_{OUT}.

La présente invention permet de réduire le nombre de bits du convertisseur analogique/numérique 47. Il est ainsi possible de conserver un convertisseur à faible coût tout en augmentant la précision de la commande de puissance du signal de sortie S'.

En outre, les éléments nécessaires à la mise en oeuvre du procédé, c'est-à-dire l'amplificateur auxiliaire 44 et le comparateur 46 peuvent être facilement réalisés sur des circuits intégrés.

Bien entendu, la présente invention est susceptible de diverses variantes et modifications qui apparaîtront à l'homme de l'art. En particulier, la présente invention peut être appliquée à tout procédé de commande en boucle fermée d'un système analogique par un système numérique dans lequel le système numérique fournit un signal de commande au système analogique et reçoit un signal de détection qui est fonction de la sortie du système analogique. Par exemple, il peut s'agir d'un système de régulation du chauffage d'un appartement. Dans ce cas, le système analogique peut correspondre à la chaudière chauffant de l'eau qui circule dans des radiateurs disposés dans l'appartement. La consigne peut être la température d'appartement souhaitée et le signal de détection peut correspondre à la température de l'eau chauffée, ou à la température de la pièce à chauffer.

## Revendications

1. Procédé de commande en boucle fermée d'un système analogique (12) recevant un signal d'entrée analogique (S) et produisant un signal de sortie (S') analogique à partir d'un signal de commande (N_{C}) constitué d'une suite de valeurs numériques et du signal d'entrée analogique, dans lequel le système analogique (12) est commandé par un signal de commande analogique (V_{C}) correspondant à la conversion du signal de commande numérique (N_{C}), ledit signal de commande numérique (N_{C}) étant fourni par un système numérique (42) qui produit les valeurs successives du signal de commande numérique (N_{C}) à partir d'un signal de référence (P_{REF}) et d'un signal de détection numérique (N"_{D}) correspondant à la conversion d'un signal de détection analogique (V"_{D}), une nouvelle valeur du signal de commande numérique (N_{C}) étant déterminée selon les étapes suivantes :
- mesurer un signal analogique (V_{D}) représentatif du signal de sortie analogique (S') ;
- déterminer le signal de détection analogique (V"_{D}) à partir de la différence entre le signal analogique représentatif (V_{D}) et le signal de commande analogique (V_{C}) multiplié par le facteur sélectionné ;
- convertir le signal de détection analogique (V"_{D}) en une nouvelle valeur de signal de détection numérique (N"_{D}) ; et
- calculer la nouvelle valeur du signal de commande numérique (N_{C}) à partir de ladite nouvelle valeur du signal de détection numérique (N"_{D}) et de la dernière valeur du signal de commande numérique (N_{C}) précédemment déterminée.

2. Procédé selon la revendication 1, dans lequel le signal analogique représentatif (V_{D}) et le signal de commande analogique (V_{C}) sont de même signe, le signal de détection analogique (V"_{D}) correspondant à la différence entre le signal analogique représentatif (V_{D}) et le signal de commande analogique (V_{C}) multiplié par un coefficient d'amplification (K).

3. Procédé selon la revendication 1, dans lequel le signal de sortie analogique (S') est une tension variable.

4. Procédé selon la revendication 1, dans lequel le signal analogique représentatif (V_{D}) est une tension positive sensiblement égale à la valeur maximale du signal de sortie analogique (S').

5. Procédé selon la revendication 1, dans lequel le signal de référence (P_{REF}) est représentatif de la puissance désirée du signal de sortie analogique (S').

6. Procédé selon la revendication 2, dans lequel le coefficient d'amplification (K) est constant.

7. Procédé selon la revendication 2, dans lequel le coefficient d'amplification (K) dépend des conditions de fonctionnement du système numérique (12).

8. Dispositif de commande d'un système analogique (12) recevant un signal d'entrée analogique (S) et produisant un signal de sortie analogique (S') comprenant :
un système numérique (42) fournissant un signal de commande numérique (N_{C}) ;
un convertisseur numérique-analogique (16) recevant le signal de commande numérique (N_{C}) et fournissant un signal de commande analogique (V_{C}) au système analogique (12) ;
un capteur (20) mesurant un signal analogique (V_{D}) représentatif du signal de sortie analogique (S'),
un comparateur (46) fournissant un signal de détection analogique (V"_{D}) à partir du signal analogique représentatif (V_{D}) et du signal de commande analogique (V_{C}) multiplié par un facteur sélectionné ; et
un convertisseur analogique-numérique (47) convertissant le signal de détection analogique (V"_{D}) en un signal de détection numérique (N"_{D}) fourni au système numérique (42), ledit système numérique déterminant le signal de commande numérique (N_{C}) à partir d'un signal de référence (P_{REF}) et du signal de détection numérique (N"_{D}).

9. Dispositif selon la revendication 8, dans lequel le système analogique (12) est un amplificateur de signaux d'un téléphone portable.

## Claims

1. A method for controlling in closed loop an analog system (12) receiving an analog input signal (S) and generating an analog output signal (S') from a control signal (N_{C}) formed of a series of digital values and of said analog input signal, wherein the analog system (12) is controlled by an analog control signal (V_{C}) corresponding to the conversion of the digital control signal (N_{C}) , said digital control signal (N_{C}) being provided by a digital system (42) which generates the successive values of the digital control signal (N_{C}) based on a reference signal (P_{REF}) and on a digital detection signal (N"_{D}) corresponding to the conversion of an analog detection signal (V"_{D}), a new value of the digital control signal (N_{C}) being determined according to the steps of:
- measuring an analog signal (V_{D}) representative of the analog output signal (S');
- determining the analog detection signal (V"_{D}) based on the difference between the representative analog signal (V_{D}) and the analog control signal (V_{C}) multiplied by the selected factor;
- converting the analog detection signal (V"_{D}) into a new digital detection signal value (N"_{D}); and
- calculating the new value of the digital control signal (N_{C}) based on said new value of the digital detection signal (N"_{D}) and on the last previously-determined value of the digital control signal (N_{C}) .

2. The method of claim 1, wherein the representative analog signal (V_{D}) and the analog control signal (V_{C}) have the same sign, the analog detection signal (V"_{D}) corresponding to the difference between the representative analog signal (V_{D}) and the analog control signal (V_{C}) multiplied by an amplification coefficient (K).

3. The method of claim 1, wherein the analog output signal (S') is a variable voltage.

4. The method of claim 1, wherein the representative analog signal (V_{D}) is a positive voltage substantially equal to the maximum value of the analog output signal (S').

5. The method of claim 1, wherein the reference signal (P_{REF}) is representative of the desired power of the analog output signal (S').

6. The method of claim 2, wherein the amplification coefficient (K) is constant.

7. The method of claim 2, wherein the amplification coefficient (K) depends on the operating conditions of the digital system (12).

8. A device for controlling an analog system (12) receiving an analog input signal (S) and providing an analog output signal (S'), comprising:
a digital system (42) providing a digital control signal (N_{C}) ;
a digital-to-analog converter (16) receiving the digital control signal (N_{C}) and providing an analog control signal (V_{C}) to the analog system (12);
a sensor (20) measuring an analog signal (V_{D}) representative of the analog output signal (S');
a comparator (46) providing an analog detection signal (V"_{D}) based on the representative analog signal (V_{D}) and on the analog control signal (V_{C}) multiplied by a selected factor; and
an analog-to-digital converter (47) converting the analog detection signal (V"_{D}) into a digital detection signal (N"_{D}) provided to the digital system (42), said digital system determining the digital control signal (N_{C}) based on a reference signal (P_{REF}) and on the digital detection signal (N"_{D}).

9. The device of claim 8, wherein the analog system (12) is an amplifier of signals of a portable telephone.

## Patentansprüche

1. Ein Verfahren zur Steuerung mit geschlossener Schleife (Regelverfahren) eines Analogsystems (12), welches ein analoges Eingangssignal (S) empfängt und ein analoges Ausgangssignal (S') erzeugt und zwar aus einem durch eine Reihe von digitalen Werten gebildeten Befehlssignal (N_{C}) und dem analogen Eingangssignal, wobei das Analogsystem (12) durch ein analoges Steuersignal (V_{C}) entsprechend der Umwandlung des digitalen Steuersignals (N_{C}) gesteuert wird, wobei dieses digitale Steuersignal (N_{C}) durch ein digitales System (42) geliefert wird, welches die aufeinanderfolgenden Werte des digitalen Steuersignals (N_{C}) erzeugt und zwar basierend auf einem Referenzsignal (P_{REF}) und einem digitalen Detektionssignal (N"_{D}) entsprechend der Umwandlung eines analogen Detektionssignals (V"_{D}), wobei ein neuer Wert des digitalen Steuersignals (N_{C}) entsprechend den folgenden Schritten bestimmt wird:
- Messen eines für das analoge Ausgangssignal (S') repräsentativen Analogsignals (V_{D}),
- Bestimmen des analogen Detektionssignals (V"_{D}) aus der Differenz zwischen dem repräsentativen Analogsignal (V_{D}) und dem analogen Steuersignal (V_{C}) multipliziert mit dem ausgewählten Faktor;
- Umwandeln des analogen Detektionssignals (V"_{D}) in einen neuen digitalen Detektionssignalwert (N"_{D}), und
- Berechnen des neuen Wertes des digitalen Steuersignals (N_{C}) aus dem genannten neuen digitalen Detetektionssignalwert (N"_{D}) und aus dem letzten zuvor bestimmten Wert des digitalen Steuersignals (N_{C}).

2. Verfahren nach Anspruch 1, wobei das repräsentative Analogsignal (V_{D}) und das analoge Befehlssignal (V_{C}) das gleiche Vorzeichen besitzen, wobei das analoge Detektionssignal (V"_{D}) einer Differenz entspricht zwischen dem repräsentativen Analogsignal (V_{D}) und dem analogen Steuersignal (V_{C}) multipliziert mit einem Verstärkungskoeffizienten (K).

3. Verfahren nach Anspruch 1, wobei das analoge Ausgangssignal (S') eine variable Spannung ist.

4. Verfahren nach Anspruch 1, wobei das repräsentative Analogsignal (V_{D}) eine positive Spannung ist, im Wesentlichen gleich dem Maximalwert des analogen Ausgangssignals (S').

5. Verfahren nach Anspruch 1, wobei das Referenzsignal (P_{REF}) repräsentativ ist für die erwünschte Leistung des analogen Ausgangssignals (S').

6. Verfahren nach Anspruch 2, wobei der Verstärkungskoeffizient (K) konstant ist.

7. Verfahren nach Anspruch 2, wobei der Verstärkungskoeffizient (K) von den Betriebsbedingungen des digitalen Systems (12) abhängt.

8. Vorrichtung zur Steuerung eines Analogsystems (12), welches ein analoges Eingangssignal (S) empfängt und ein analoges Ausgangssignal (S') erzeugt wobei Folgendes vorgesehen ist:
ein digitales System (42), welches ein digitales Steuersignal (N_{C}) liefert; einen digitalen Analogwandler (16), der das digitale Steuersignal (N_{C}) empfängt und ein Analogsignal (V_{C}) an das analoges Steuersignal (12) liefert;
einen Sensor (20) zum Messen eines Analogsignals (V_{D}) repräsentativ für das analoge Ausgangssignal (S');
ein Komparator (46) zur Lieferung eines analogen Detektionssignal (V"_{D}) und zwar basierend auf dem repräsentativen Analogsignal (V_{D}) und auf dem analogen Steuersignal (V_{C}) multipliziert mit einem ausgewählten Faktor; und
ein Analog-zu-Digital-Konverter (47) zum Konvertieren des analogen Detektionssignals (V"_{D}) in ein digitales Detektionssignals (N"_{D}) geliefert an das Digitalsystem (42), wobei das Digitalsystem das digitale Steuersignal (N_{C}) bestimmt, und zwar basierend auf einem Bezugssignal (P_{REF}) und auf dem digitalen Detektionssignal (N"_{D}).

9. Vorrichtung nach Anspruch 8, wobei das analoge System (12) ein Verstärker von Signalen eines tragbaren Telefons ist.
